(19) Europäisches Patentamt
European Patent Office
Office européen des brevets

(11) Veröffentlichungsnummer: **0 054 700**
**B1**

(12) # EUROPÄISCHE PATENTSCHRIFT

(45) Veröffentlichungstag der Patentschrift: **13.02.85**

(21) Anmeldenummer: **81109005.9**

(22) Anmeldetag: **27.10.81**

(51) Int. Cl.⁴: **G 03 C 1/70**, C 08 L 75/06, C 08 F 2/46, C 08 F 2/50, C 08 F 220/36 // G03F7/10, G03F7/26

(54) **Durch Strahlung polymerisierbares Gemisch und daraus hergestelltes strahlungsempfindliches Aufzeichnungsmaterial.**

(30) Priorität: **22.12.80 DE 3048502**

(43) Veröffentlichungstag der Anmeldung: **30.06.82 Patentblatt 82/26**

(45) Bekanntmachung des Hinweises auf die Patenterteilung: **13.02.85 Patentblatt 85/7**

(84) Benannte Vertragsstaaten: **AT BE CH DE FR GB IT LI NL SE**

(56) Entgegenhaltungen:
**EP - A - 0 009 967**
**DE - A - 2 822 190**
**US - A - 3 850 770**

(73) Patentinhaber: **HOECHST AKTIENGESELLSCHAFT, Postfach 80 03 20, D-6230 Frankfurt am Main 80 (DE)**

(72) Erfinder: **Geissler, Ulrich, Dr., Ruprechtstrasse 22, D-6000 Frankfurt/Main (DE)**
Erfinder: **Herwig, Walter, Dr., Hasenpfad 7, D-6232 Bad Soden/Taunus (DE)**
Erfinder: **Sprengel, Heide, Elsa-Brandström-Strasse 10, D-6200 Wiesbaden 12 (DE)**
Erfinder: **Hasenjäger, Manfred, Zeisigweg 8, D-6200 Wiesbaden-Nordenstadt (DE)**

Anmerkung: Innerhalb von neun Monaten nach der Bekanntmachung des Hinweises auf die Erteilung des europäischen Patents im Europäischen Patentblatt kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

EP 0 054 700 B1

BUNDESDRUCKEREI BERLIN

**Beschreibung**

Die Erfindung betrifft ein durch Strahlung, insbesondere durch Licht, polymerisierbares Gemisch, das als wesentliche Bestandteile ein polymeres Bindemittel, einen durch Strahlung aktivierbaren Polymerisationsinitiator und einen radikalisch polymerisierbaren Acryl- oder Methacrylsäureester einer mehrwertigen Hydroxyverbindung mit mindestens zwei Urethangruppen im Molekül enthält.

Gemische dieser Gattung sind bekannt und werden vorwiegend zur Herstellung strahlungsempfindlicher, insbesondere lichtempfindlicher Aufzeichnungsmaterialien verwendet, die z. B. zur Herstellung von Druckplatten, Photoresists und Reliefbildern dienen.

In der DE-A-2 064 079 sind photopolymerisierbare Gemische beschrieben, die als polymerisierbare Verbindungen Umsetzungsprodukte von Acrylaten oder Methacrylaten mehrwertiger Alkohole, die noch mindestens eine freie Hydroxygruppe enthalten, z. B. von Hydroxyethylmethacrylat, mit Diisocyanaten enthalten. Diese Gemische neigen zur Bildung von relativ spröden Lichthärtungsprodukten. Sie haben ferner eine begrenzte Lagerfähigkeit, da die Monomeren bei leicht erhöhter Temperatur bereits einen merklichen Dampfdruck aufweisen.

In der DE-A-2 361 041 sind Gemische beschrieben, die ähnliche polymerisierbare Verbindungen enthalten, die mehr als zwei Urethangruppen und zusätzlich Polyethereinheiten im Molekül aufweisen. Diese Gemische ergeben nur eine begrenzte Vernetzungsdichte und sind relativ empfindlich gegen Luftsauerstoff.

In der DE-A-2 822 190 sind Gemische mit höhermolekularen, Urethangruppen enthaltenden Monomeren beschrieben, die für bestimmte Zwecke, z. B. zur Herstellung von trocken übertragbaren Photoresistschichten, viele Vorteile aufweisen. Auch sie ergeben jedoch wegen ihres geringeren Gehalts an polymerisierbaren Gruppen je Molekulargewichtseinheit Produkte mit begrenzter Vernetzungsdichte.

In den US-A-3 850 770 und 4 198 238 sowie der EP-A-9 967 sind ähnliche polymerisierbare Oligourethane beschrieben.

Die mit solchen polymerisierbaren Verbindungen hergestellten licht- bzw. strahlungsempfindlichen Aufzeichnungsmaterialien haben zwar eine Reihe hervorragender Eigenschaften, die jedoch in den meisten Fällen zusammen mit bestimmten Nachteilen auftreten. So ergeben zwar die höhermolekularen, Polyethergruppen enthaltenden Oligourethane Schichten mit hervorragenden mechanischen Eigenschaften im belichteten und unbelichteten Zustand, doch ist die damit erzielte Vernetzungsdichte geringer als bei bestimmten niedermolekularen Monomeren. Auch ergeben viele Monomere, insbesondere in Kombination mit den bevorzugten wäßrig-alkalisch entwickelbaren Bindemitteln klebrige Schichten. Auch ist die Empfindlichkeit der meisten bekannten Materialien gegenüber Luftsauerstoff größer als dies wünschenswert ist.

Aufgabe der Erfindung war es, ein durch Strahlung polymerisierbares Gemisch vorzuschlagen, das eine hohe Strahlungsempfindlichkeit und keine Kristallisationsneigung aufweist, aber dennoch Schichten mit nicht klebriger Oberfläche ergibt. Insbesondere sollte das Gemisch seine vorteilhafte Eigenschaft auch in Anwesenheit von Luftsauerstoff, d. h. ohne sauerstoffhemmende Deckschicht, entfalten und dabei eine möglichst gute Reziprozität aufweisen.

Gegenstand der Erfindung ist ein durch Strahlung polymerisierbares Gemisch, das als wesentliche Bestandteile ein polymeres Bindemittel, einen durch Strahlung aktivierbaren Polymerisationsinitiator und einen Acryl- oder Methacrylsäureester einer mehrwertigen Hydroxyverbindung mit mindestens zwei Urethangruppen im Molekül enthält.

Das erfindungsgemäße Gemisch ist dadurch gekennzeichnet, daß der Ester ein Umsetzungsprodukt aus Glycerindimethacrylat oder Glycerindiacrylat und einem mehrwertigen Isocyanat, das durch Umsetzen einer Polyhydroxyverbindung mit 2 bis 6 OH-Gruppen mit einem Diisocyanat erhalten worden ist, oder einem Diisocyanat ist.

Die Polyhydroxyverbindung hat vorzugsweise 2 oder 3, insbesondere 2 OH-Gruppen. Sie ist vorzugsweise eine Verbindung einer der folgenden allgemeinen Formeln

$HO-[C_pH_{2p-v}(OH)_v-S-]_{m-1}C_pH_{2p-v}(OH)_{v+1}$,

$HO-[C_pH_{2p-v}(OH)_v-O-]_mH$,

$HO-C_rH_{2r-2-v}(OH)_{v+1}$,

$HO-C_sH_{2s-v}(OH)_v-Z(-CO-C_qH_{2q}-O)_m-H$,

$HO-[C_qH_{2q-v}(OH)_v-O-CO-Q-COO]_m-C_qH_{2q-v}(OH)_{v+1}$ und

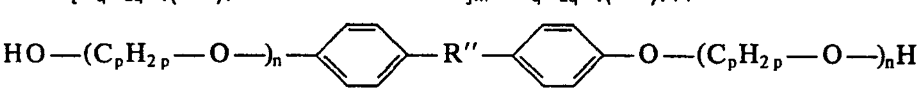

worin

R'' O, S, $CR_2$ oder $SO_2$,

Q eine Phenylengruppe oder eine der Gruppen

$C_qH_{2q}$ und

$C_qH_{2q\ 2}$,

R ein Wasserstoffatom oder eine Methylgruppe,
Z O oder NR,
n eine Zahl von 0 bis 20,
m eine Zahl von 1 bis 40,
p eine Zahl von 2 bis 20,
q eine Zahl von 2 bis 10,
r eine Zahl von 4 bis 20,
s eine Zahl von 2 bis 10 und
v eine Zahl von 0 bis 4

bedeuten, wobei p, q und s um mindestens 2 und r um mindestens 4 größer sind als v.

Das Diisocyanat ist im allgemeinen eine Verbindung der Formel OCN—X—NCO, worin X ein Kohlenwasserstoffrest, vorzugsweise ein gesättigter aliphatischer oder cycloaliphatischer Kohlenwasserstoffrest, mit 2 bis 20 Kohlenstoffatomen ist.

Die Umsetzungsprodukte des Glycerindimethacrylats werden im allgemeinen gegenüber denen des Glycerinacrylats bevorzugt.

Das mehrwertige Isocyanat, das durch Umsetzen von Polyhydroxyverbindung mit Diisocyanat erhalten wird, enthält im Mittel 2 bis 40, vorzugsweise 2 bis 20 Urethangruppen im Molekül.

Als elektromagnetische Strahlung, gegenüber der das erfindungsgemäße Gemisch empfindlich ist, kommt jede Strahlung in Betracht, deren Energie mindestens der des kurzwelligen sichtbaren Lichts entspricht. Bevorzugt wird Licht einer Wellenlänge im Bereich von 300 bis 500 nm, es sind aber auch Röntgen-, Elektronen- und andere Korpuskularstrahlung sowie Laserstrahlung zur Auslösung der Polymerisation geeignet. In jedem Fall kann in bekannter Weise das Initiatorsystem der gewünschten Strahlung angepaßt bzw. für diese sensibilisiert werden.

Von den zur Herstellung der polymerisierbaren Urethane verwendeten Polyolkomponenten werden die Polyetherpolyole, besonders die gesättigten Vertreter, als Verbindungen der Formel

$$HO-[C_pH_{2p-v}(OH)_v-O-]_mH,$$

bevorzugt. Dabei werden für p Werte von 2 bis 10, insbesondere von 2 bis 4, bevorzugt. Wenn ungesättigte Polyole verwendet werden, haben diese je Polyoleinheit vorzugsweise 4 bis 10 Kohlenstoffatome.

Für bestimmte Zwecke, z. B. zur Erzielung bestimmter mechanischer Eigenschaften oder höherer Lichtempfindlichkeiten, kann es auch vorteilhaft sein, Polyesterpolyole zu verwenden. Diese können in bekannter Weise aus Dicarbonsäure- und Polyoleinheiten oder aus Hydroxycarbonsäureeinheiten aufgebaut sein. Dabei werden als Hydroxycarbonsäuren solche mit q = 3 bis 6 bevorzugt.

Die Polyesterdiole aus Hydroxycarbonsäuren werden gewöhnlich aus Lactonen durch Ringöffnung mit einem Molekül H-aktiver Verbindung

$$HO-C_sH_{2s}-Z-H$$

hergestellt. Hierin hat s bevorzugt einen Wert von 2 bis 6, Z ist bevorzugt ein Sauerstoffatom

Die Anzahl der Einheiten in den Polyesterdiolen und Polyetherdiolen hängt von der Natur dieser und der übrigen Einheiten des Moleküls, der Natur des Bindemittels und von dem jeweiligen Verwendungszweck ab. Polymerisierbare Verbindungen mit relativ langen Polyoxyethylenketten im Molekül sind sehr hydrophil und werden mit wäßrigen Entwicklern sehr rasch entwickelt. Auch bei Verwendung weniger hydrophiler Bindemittel sind Monomere mit solchen Polyethergruppen im allgemeinen gut geeignet. Dagegen ist bei Monomeren, die Polyoxyalkylengruppen mit höheren Alkylenresten oder Polyestergruppierungen enthalten, die Verwendung von hydrophileren Bindemitteln erforderlich, wenn das Material ohne Zusatz organischer Lösungsmittel zum Entwickler entwickelt werden soll. In den meisten Fällen werden Verbindungen mit m = 2 bis 25, insbesondere 3 bis 15, bevorzugt.

Beispiele für geeignete Diisocyanate sind Tolylendiisocyanate, Xylylendiisocyanate, Naphthylendiisocyanate, Hexamethylendiisocyanat, Cyclohexylendiisocyanat, Diphenylmethandiisocyanat, Isophorondiisocyanat, 2,2,4-Trimethylhexamethylendiisocyanat und das Reaktionsprodukt aus 2 Mol Tolylendiisocyanat oder Diphenylmethandiisocyanat und 1 Mol Polytetrahydrofuran.

Beispiele für geeignete monomere oder polymere Diole sind Ethylenglykol, Propylenglykol, Butandiol-(1,4), 2-Ethylhexandiol-(1,6), Decandiol-(1,10), 1,4-Bis-hydroxymethylcyclohexan, Diethylenglykol, Triethylenglykol, Polyethylenglykole mit Molekulargewichten von 200 bis etwa 1500, die Reaktionsprodukte von 4,4'-Dihydroxy-diphenylether, -diphenylsulfid, -diphenylmethan, -diphenylpropan oder -diphenylsulfon mit 0 bis 40 Mol Alkylenoxid, Polypropylenglykole, Polytetrahydrofuran, Polybutylenglykole, Thiodiethylenglykol und Dithiotriethylenglykol.

Beispiele für geeignete Polyesterkomponenten sind Polycaprolacton, Polybutyrolacton, Polyethylenterephthalat, Polypropylenadipat, Polybutylenadipat und Polyethylenbutylensebacat.

Allgemein sind Polyesterpolyole mit Molekulargewichten im Bereich von etwa 500 bis 3000 gut geeignet.

Außer den bevorzugten Diolen können allgemein Verbindungen mit 2 bis 6 aliphatischen Hydroxygruppen verwendet werden. Beispiele für monomere Verbindungen sind Glycerin, Trimethylolpropan, Pentaerythrit, Dipentaerythrit und Sorbit. Als polymere Polyhydroxyverbindungen sind Polyesterpolyole, wie die in der US-A-3 169 945 beschriebenen Lactonpolyester, die in der US-A-3 641 199 beschriebenen Polyester-Kondensationspolymerisate mit endständigen Hydroxygruppen, die in der US-A-3 931 117 beschriebenen Hydroxygruppen enthaltenden Polyester, Blockmischpolymerisate aus Polyethern und Polyestern mit endständigen Hydroxygruppen, Caprolactonpolyole und Polysiloxanpolyole geeignet.

Die Herstellung der polymerisierbaren Di- bzw. Polyurethane erfolgt in an sich bekannter Weise, z. B. wie es in der US-A-3 297 745, der DE-A-2 064 079 und der DE-A-2 822 190 beschrieben ist.

Man setzt zunächst zur Herstellung des Glycerindiesters 1 Mol Glycidylacrylat oder Glycidylmethacrylat mit 1 Mol Acryl- oder Methacrylsäure um. Anschließend wird 1 Mol von diesem Reaktionsprodukt mit 1 Äquivalent Polyisocyanat umgesetzt. Das Poly-, vorzugsweise Diisocyanat, ist dabei entweder monomer oder ein Reaktionsprodukt von monomerem Diisocyanat im Überschuß mit Polyolkomponente. Im letzteren Falle wird zuvor die Polyolkomponente mit dem gewünschten Überschuß an Diisocyanat umgesetzt. Dabei werden in der Regel polymerhomologe Gemische erhalten. Die Uneinheitlichkeit der Molekulargewichte der daraus erhaltenen Monomeren führt zu Produkten, die hochviskos und praktisch nicht kristallisierbar sind.

Außer den oben beschriebenen neuen Monomeren kann das erfindungsgemäße Gemisch kleinere Mengen, d. h. weniger als 50%, bevorzugt weniger als 20%, bezogen auf den Gesamtmonomerengehalt, an bekannten Monomeren, insbesondere Acryl- oder Methacrylsäureestern mehrwertiger Alkohole, enthalten, die gegebenenfalls auch Urethanbindungen enthalten können. Die Gesamtmenge an polymerisierbaren Verbindungen beträgt im allgemeinen 20 bis 80, bevorzugt 30 bis 70 Gew.-% der nichtflüchtigen Bestandteile des Gemischs.

Als Photoinitiatoren eignen sich eine Vielzahl von Substanzen, beispielsweise Benzoin, Benzoinether, Mehrkernchinone, z. B. 2-Ethyl-anthrachinon; Acridinderivate, z. B. 9-Phenyl-acridin, 9-p-Methoxyphenyl-acridin, 9-Acetylamino-acridin, Benz(a)acridin; Phenazinderivate, z. B. 9,10-Dimethylbenz(a)phenazin, 9-Methyl-benz(a)-phenazin, 10-Methoxy-benz(a)phenazin; Chinoxalinderivate, z. B. 6,4',4''-Trimethoxy-2,3-diphenyl-chinoxalin, 4',4''-Dimethoxy-2,3-diphenyl-5-aza-chinoxalin und Chinazolinderivate.

Die Photoinitiatoren werden im allgemeinen in einer Menge von 0,1 bis 20 Gew.-%, bezogen auf die nicht flüchtigen Bestandteile des photopolymerisierbaren Gemischs, zugesetzt.

Als Bindemittel können eine Vielzahl löslicher organischer Polymerisate Einsatz finden. Als Beispiele seien genannt: Polyamide, Polyvinylester, Polyvinylacetale, Polyvinylether, Polyacrylsäureester, Polymethacrylsäureester, Polyester, Alkydharze, Polyacrylamid, Polyvinylalkohol, Polyethylenoxid, Polydimethylacrylamid, Polyvinylpyrrolidon, Polyvinylmethylformamid, Polyvinylmethylacetamid sowie Mischpolymerisate der Monomeren, die die aufgezählten Homopolymerisate bilden.

Ferner kommen als Bindemittel Naturstoffe oder umgewandelte Naturstoffe in Betracht, z. B. Gelatine und Celluloseether.

Mit besonderem Vorteil werden Bindemittel verwendet, die in wäßrig-alkalischen Lösungen löslich oder mindestens quellbar sind, da sich Schichten mit solchen Bindemitteln mit den bevorzugten wäßrig-alkalischen Entwicklern entwickeln lassen. Derartige Bindemittel können z. B. die folgenden Gruppen enthalten: $-COOH$, $-PO_3H_2$, $-SO_3H$, $-SO_2NH_2$, $-SO_2-NH-CO-$ und dgl. Als Beispiele hierfür seien genannt: Maleinatharze, Polymerisate aus N-(p-Tolyl-sulfonyl)-carbaminsäure-(β-methacryloyloxy-ethyl)-ester und Mischpolymerisate dieser und ähnlicher Monomerer mit anderen Monomeren, Styrol-Maleinsäureanhydrid-Mischpolymerisate, Mischpolymerisate aus Methylvinylether und Maleinsäureanhydrid oder Maleinsäureestern bzw. -halbestern, Methylmethacrylat-Methacrylsäure-Mischpolymerisate und Mischpolymerisate aus Methacrylsäure, Alkylmethacrylaten und Methylmethacrylat und/oder Styrol, Acrylnitril u. a., wie sie in den DE-A-2 064 080 und 2 363 806 beschrieben sind. Mischpolymerisate von Styrol und Maleinsäureanhydrid oder Maleinsäureestern bzw. -halbestern, ggf. in Kombination mit Mischpolymerisaten aus Methylvinylether und Maleinsäurehalbestern, werden besonders bevorzugt.

Die Menge des Bindemittels beträgt im allgemeinen 20 bis 80, vorzugsweise 30 bis 70 Gew.-% der Bestandteile des Gemischs.

Das photopolymerisierbare Gemisch enthält außer Monomeren, Bindemitteln und Photoinitiatoren noch gegebenenfalls Stabilisatoren bzw. Inhibitoren zur Verhinderung der Dunkelpolymerisation der Monomeren, Wasserstoffdonatoren, Netzmittel, Weichmacher, sensitometrische Regler, Farbstoffe und farblose oder Farbpigmente.

Als Wasserstoffdonatoren werden in der Hauptsache aliphatische Polyether verwendet. Gegebenenfalls kann diese Funktion auch vom Bindemittel oder von dem polymerisierbaren Monomeren übernommen werden, wenn diese labile Wasserstoffatome besitzen.

Es kann vorteilhaft sein, die photopolymerisierbare Schicht des aus dem Gemisch hergestellten photopolymerisierbaren Aufzeichnungsmaterials während der Lichtpolymerisation dem Einfluß des Luftsauerstoffes weitgehend zu entziehen, d. h. vor allem die Nachdiffusion des Luftsauerstoffs in die Schicht zu verhindern. Dies ist normalerweise besonders wichtig, wenn man — z. B. bei der Belichtung

durch Projektion oder mit Laserstrahlung — ohne Vakuumkopierrahmen arbeitet. Im Fall der Anwendung des Gemischs in Form dünner Kopierschichten ist es zweckmäßig, einen geeigneten, für Sauerstoff wenig durchlässigen Deckfilm aufzubringen. Dieser kann selbsttragend sein und vor der Entwicklung der Kopierschicht abgezogen werden. Für diesen Zweck sind z. B. Polyesterfilme geeignet. Der Deckfilm kann auch aus einem Material bestehen, das sich in der Entwicklerflüssigkeit löst oder mindestens an den nicht gehärteten Stellen bei der Entwicklung entfernen läßt. Hierfür geeignete Materialien sind z. B. Wachse, Polyvinylalkohol, Polyphosphate, Zucker usw.

Die erfindungsgemäßen Gemische ergeben fotopolymerisierbare Schichten mit hoher Lichtempfindlichkeit. Diese ist auch dann gegeben, wenn auf eine Sauerstoff abschirmende Deckschicht verzichtet wird. Die Schichten zeigen auch ohne Deckschicht keine Klebeneigung und sind im belichteten Zustand beständig gegen alkalische Entwickler und saure alkoholische Wischwässer. Die neuen polymerisierbaren Urethane mit Polyglykoleinheiten begünstigen außerdem die wäßrig-alkalische Entwicklung, ohne die Entwicklerresistenz zu beeinträchtigen. Druckplatten mit photopolymerisierbaren Schichten, die solche polymerisierbaren Urethane enthalten, lassen sich durch Tauchen in eine mit Entwickler gefüllte Küvette entwickeln.

Die Herstellung der lichtempfindlichen Materialien unter Verwendung des erfindungsgemäßen Gemischs erfolgt in bekannter Weise. So kann man dieses in einem Lösungsmittel aufnehmen und die Lösung bzw. Dispersion durch Gießen, Sprühen, Tauchen oder Antragen mit Walzen auf den vorgesehenen Träger als Film aufbringen und anschließend trocknen.

Die Art des Schichtträgers richtet sich nach dem Verwendungszweck des lichtempfindlichen Materials. Zur Herstellung von Flachdruckplatten wird im allgemeinen Aluminium verwendet, das bevorzugt eine anodisch erzeugte poröse Oxidschicht trägt. Das Aluminium wird zweckmäßig vor dem Anodisieren mechanisch, chemisch oder elektrolytisch aufgerauht. Die Anodisierung erfolgt in bekannter Weise, z. B. in Schwefel- und/oder Phosphorsäure, vorzugsweise unter solchen Bedingungen, daß eine Oxidschicht mit einem Schichtgewicht von etwa 0,5 bis 10 $g/m^2$ erhalten wird.

Vorteilhaft wird die Oxidschicht vor dem Aufbringen der lichtempfindlichen Schicht einer Vorbehandlung zur Verbesserung des drucktechnischen Verhaltens, insbesondere der Hydrophilie, unterworfen, z. B. mit Silikaten oder Polyvinylphosphonsäure.

Außer Aluminium und Aluminiumlegierungen können auch Stahl, Zink, Kupfer, Nickel, verchromter Stahl oder verchromtes Kupfer, auf Silicium thermisch gewachsene oder abgeschiedene Siliciumdioxidschichten oder dotierte Oxidschichten, Kunststoffolien, z. B. aus Polyethylenterephthalat oder Celluloseacetat, oder Siebdruckträger, z. B. Perlongaze oder Nickelsiebe, verwendet werden.

Die Bebilderung der Aufzeichnungsmaterialien erfolgt in bekannter Weise, z. B. durch Kontaktbelichtung unter einer Transparentvorlage. Dabei werden die üblichen Lichtquellen, wie Kohlenbogenlampen, Xenonlampen, mit Metallhalogeniden dotierte Quecksilberhochdrucklampen und dgl. verwendet. Die Bebilderung kann auch mit Laserlicht erfolgen, z. B. mit einem Argon-Ionen-Laser.

Die Entwicklung der belichteten Aufzeichnungsmaterialien erfolgt in bekannter Weise durch Auswaschen der unbelichteten Schichtbereiche mit einem Entwickler. Die Zusammensetzung des Entwicklers richtet sich nach der Natur und Löslichkeit der lichtempfindlichen Schicht. Geeignete Entwickler sind organische Lösungsmittel oder Lösungsmittelgemische, Wasser, das kleine Mengen organischer Lösungsmittel oder Netzmittel enthalten kann, und insbesondere alkalische wäßrige Lösungen, die Puffersalze, z. B. Alkaliphosphate oder -silikate, organische Lösungsmittel, Netzmittel, Farbstoffe und andere übliche Zusätze enthalten können. Bevorzugt werden Entwickler, die frei von organischen Lösungsmitteln sind.

Die erfindungsgemäßen Gemische eignen sich besonders in Form eines vorsensibilisierten Kopiermaterials auf einem geeigneten Träger für die fotomechanische Herstellung von Offsetdruckplatten. Sie sind ferner für die Herstellung von Trockenresistfolien, Reliefbildern, Siebdruckschablonen und Farbprüffolien geeignet, außerdem ist eine Verwendung als Flüssigresist möglich. Sie sind auch brauchbar als schnellhärtende Überzugsmassen, Zahnfüllmassen, Klebstoffe und zur Herstellung harter, thermostabiler Formkörper.

Die folgenden Beispiele erläutern Ausführungsformen des erfindungsgemäßen Gemisches und deren Verwendung zur Herstellung von photopolymerisierbaren Kopiermaterialien. Prozentangaben und Mengenverhältnisse sind, wenn nichts anderes angegeben ist, in Gewichtseinheiten zu verstehen.

### Beispiel 1

Als Schichtträger für Druckplatten wurde elektrochemisch aufgerauhtes und anodisiertes Aluminium mit einer Oxidschicht von 2 $g/m^2$ verwendet, das mit einer wäßrigen Lösung von Polyvinylphosphonsäure vorbehandelt worden war.

Es wurde eine Lösung aus

| | |
|---|---|
| 2 Gt | eines teilweise mit Alkanol veresterten Styrol-Maleinsäureanhydrid-Mischpolymerisats mit einem mittleren Molekulargewicht von 20 000 und einer Säurezahl um 200, |
| 2 Gt | des unten beschriebenen Diurethans, |

| | |
|---|---|
| 0,125 Gt | 9-Phenyl-acridin und |
| 0,05 Gt | eines blauen Farbstoffs, erhalten durch Kuppeln von 2,4-Dinitro-6-chlor-benzol-diazoniumsalz mit 2-Methoxy-5-acetylamino-N-cyanethyl-N-hydroxyethyl-anilin in |
| 25 Gt | Butanon und |
| 12 Gt | Butylacetat |

auf den oben beschriebenen Träger aufgeschleudert. Anschließend wurde die Platte 2 Minuten bei 100° C im Umlufttrockenschrank getrocknet. Es wurde ein Schichtgewicht von 3,7—4 g/m² erhalten.

Die erhaltene Druckplatte wurde mittels einer 5-kW-Metallhalogenidlampe im Abstand von 110 cm zwischen Lampe und Vakuumkopierrahmen unter einem 13stufigen Belichtungskeil mit Dichteinkrementen von 0,15 40 Sekunden belichtet.

Anschließend wurde die Platte manuell mit einem Entwickler folgender Zusammensetzung entwikkelt:

| | |
|---|---|
| 3,0 Gt | Natriummetasilikat · 9 $H_2O$, |
| 0,03 Gt | nichtionogenes Netzmittel (Kokosfettalkohol-Polyoxyethylenether mit ca. 8 Oxyethyleneinheiten), |
| 0,003 Gt | Antischaummittel, |
| 0,02 Gt | Nitrilotriessigsäure, |
| 0,053 Gt | Strontiumchlorid · 6 $H_2O$, |
| 96,894 Gt | vollentsalztes Wasser. |

Es wurden 5 vollvernetzte Keilstufen erhalten.

## Herstellung von Glycerindimethacrylat

Zu einer Mischung aus 860,9 g (10 Mol) Methacrylsäure, 21,4 g Benzyltriethylammoniumchlorid und 5 g p-Methoxyphenol wurden unter Rühren innerhalb von 3 Stunden 1282,5 g (9 Mol) Glycidylmethacrylat bei 75— 85° C zugetropft. Es wurde 2 Stunden bei 80° C nachgerührt, die Lösung anschließend in verdünnte Natriumbicarbonatlösung gegossen und einige Zeit gerührt. Die organische Phase wurde abgetrennt und nochmals mit Natriumbicarbonatlösung gewaschen. Das Produkt wurde über Natriumsulfat getrocknet und nach dem Filtrieren mit 15 g p-Methoxyphenol stabilisiert. Es wurden jeweils kleine Portionen von ca. 150 g bei 0,07 mbar und 140° C Badtemperatur fraktioniert destilliert. Kp (0,08 mbar) 115° C.

Ausbeute: 1541 g = 75% d. Th.

Beim Destillieren tritt teilweise Polymerisation ein.

Analyse:
ber.:C: 57,89; H: 7,02;
gef.:C: 57,7; H: 7,05;
ber.:OH-Zahl: 245,8; Br-Zahl: 491,6; Vers. Zahl: 140;
gef.:OH-Zahl: 247; Br-Zahl: 489; Vers. Zahl: 135.

## Synthese des Diurethans

In einem Dreihalskolben mit Rührer, Rückflußkühler mit aufgesetztem $CaCl_2$-Trockenrohr und Tropftrichter wurden 336,4 g (2 Mol) Hexamethylendiisocyanat und 4 g Benzochinon in 350 g Butanon vorgelegt. Nach Zugabe einer Katalysatorlösung aus 0,85 g Eisen-(III)-acetylacetonat und 0,06 g Triethylamin in 40 ml Butanon wurden 913 g (4 Mol) Glycerindimethacrylat in 900 g Butanon innerhalb von 2,5 Stunden bei 80° C zugetropft.

Es wurde 2 Stunden bei 80° C nachgerührt, dann wurden 8 ml Ethanol zugegeben, und es wurde nochmals 1 Stunde bei 80° C gerührt. Die ca. 50%ige Lösung des Diurethans in Butanon wurde direkt zur Herstellung der Beschichtungslösung eingesetzt.

## Beispiel 2

Die in Beispiel 1 angegebene Beschichtungslösung wurde mit 0,04 Gt amorpher hochporöser Kieselsäure mit einer mittleren Teilchengröße von 8 μm versetzt und auf den Schichtträger so aufgeschleudert, daß ein Schichtgewicht von 4 g/m² erhalten wurde.

Die Platte wurde in gleicher Weise wie in Beispiel 1 weiterverarbeitet.

Es wurden 5 vollvernetzte Keilstufen erhalten.

Die Druckplatte erreichte im konventionellen Feuchtwerk eine Auflage von 170 000 Bogen, im

Alkoholfeuchtwerk eine von 70 000 Bogen.

## Beispiel 3

Eine Beschichtungslösung wurde aus

| | |
|---|---|
| 1 Gt | eines Methylmethacrylat-Methacrylsäure-Mischpolymerisats mit einem Molekulargewicht von 30 000 und einer Säurezahl von 117, |
| 1 Gt | des in Beispiel 1 angegebenen Mischpolymerisats, |
| 2 Gt | eines Diurethans aus 2 Mol Glycerindimethacrylat und 1 Mol 2,2,4-Trimethyl-hexamethylendiisocyanat, |
| 0,125 Gt | 9-Phenyl-acridin, |
| 0,07 Gt | des in Beispiel 1 angegebenen Farbstoffs und |
| 0,04 Gt | der in Beispiel 2 angegebenen Kieselsäure in |
| 28 Gt | Butanon und |
| 12 Gt | Butylacetat |

hergestellt und auf den in Beispiel 1 beschriebenen Aluminiumträger so aufgeschleudert, daß ein Trockenschichtgewicht von 5 $g/m^2$ erhalten wurde.

Belichtung, Entwicklung und Beurteilung erfolgten wie in Beispiel 1.

Es wurden 4 vollvernetzte Keilstufen erhalten.

## Beispiel 4

Auf den in Beispiel 1 angegebenen Schichtträger wurde eine Lösung folgender Zusammensetzung so aufgeschleudert, daß nach dem Trocknen ein Schichtgewicht von 1,8 $g/m^2$ erhalten wurde:

| | |
|---|---|
| 2 Gt | des in Beispiel 1 angegebenen Mischpolymerisats, |
| 1,6 Gt | des unten beschriebenen Oligourethans, |
| 0,5 Gt | 9-Phenyl-acridin und |
| 0,05 Gt | des in Beispiel 1 angegebenen Farbstoffs in |
| 25 Gt | Butanon, |
| 12 Gt | Butylacetat und |
| 20 Gt | Ethylenglykolmonomethylether. |

Belichtung und Entwicklung erfolgten wie in Beispiel 1. Es wurden 7 vollvernetzte Keilstufen erhalten.

Die Druckplatte ließ sich auch in einer Entwicklerküvette entwickeln. Dazu wurde sie nach der Belichtung in eine mit dem in Beispiel 1 beschriebenen Entwickler gefüllte Küvette eingehängt. Nach ca. 2 Minuten war die Platte entwickelt. Sie mußte lediglich mit Wasser abgebraust werden.

## Synthese des Oligourethans

In einem Dreihalskolben mit Rührer, Rückflußkühler mit aufgesetztem Trockenrohr und Tropftrichter wurden 336,4 g (2 Mol) Hexamethylendiisocyanat in 660 g Butanon vorgelegt.

Nach Zugabe einer als Katalysator wirkenden Mischung aus

| | |
|---|---|
| 0,07 g | Eisen-(III)-acetylacetonat und |
| 0,005 g | Triethylamin in |
| 5 ml | Butanon |

wurden 400 g (1 Mol) Polyethylenglykol 400, gelöst in 330 g Butanon, innerhalb 1,5 Stunden bei 70° C zugetropft. Die Mischung wurde dann 2 Stunden auf 70° C erwärmt. Es wurden 4 g Benzochinon und 5 ml der oben beschriebenen Katalysatorlösung zugegeben, und dann wurde eine Lösung von 456,5 g (2 Mol) des in Beispiel 1 beschriebenen Glycerindimethacrylats in 330 g Butanon innerhalb 1 Stunde bei 70° C zugetropft. Nach Ende der Zugabe wurde noch 2,5 Stunden bei 70° C gerührt, dann wurden 20 ml Ethanol zugegeben, und das Gemisch wurde nochmals 1 Stunde auf 70° C erhitzt.

Nach dem Abdestillieren des Lösungsmittels wurde die Mischung mit 5 l Wasser ausgeschüttelt. Durch Zusatz von ca. 200 ml 15%iger NaCl-Lösung wurde die Emulsionsbildung verhindert. Nach dem Aufnehmen in 500 ml Essigester wurde erneut mit 5 l Wasser ausgewaschen. Die organische Phase wurde abgetrennt, mit weiteren 2,1 l Essigester verdünnt und über Natriumsulfat getrocknet.

Durch Zusatz von 1,4 l Gasolin (Siedebereich 40—80° C) wurde ein öliges Produkt ausgefällt, es

wurde in 2 l Essigester aufgenommen und erneut mit 1,1 l Gasolin gefällt.

Nach dem Stabilisieren mit 2,4 g (ca. 0,3%) p-Methoxyphenol wurde bei ca. 40°C Badtemperatur das anhaftende Lösungsmittel entfernt.

Ausbeute:674 g = 56,5% d. Th.

Die Molekulargewichtsverteilung des erhaltenen Produkts wurde durch Gelchromatographie gegen das in Beispiel 1 beschriebene Diurethan als Vergleich ermittelt.

Die Auswertung ergab für Homologe mit 4 Urethangruppen einen Mengenanteil von ungefähr 15%, mit 6 Urethangruppen ungefähr 24% und mit mehr als 6 Urethangruppen ungefähr 58,5%.

## Beispiel 5

Eine wie in Beispiel 4 beschichtete Platte wurde nach dem Trocknen mit einer Polyvinylalkohol-Deckschicht von 4 g/m$^2$ versehen.

Proben dieser Platte wurden mittels einer Metallhalogenidlampe unter einem 13stufigen Belichtungskeil mit Dichteinkrementen von 0,15 jeweils 5, 10, 20 oder 40 Sekunden belichtet und danach mit der in Beispiel 1 beschriebenen Entwicklerlösung entwickelt.

In einem weiteren Versuch wurden Proben der gleichen Platte nach dem Belichten 5 Sekunden bei 100°C im Umlufttrockenschrank erhitzt und anschließend entwickelt.

Die folgende Tabelle zeigt, daß die Schicht streng reziprok arbeitet und daß der Nacherhitzungsschritt eine deutliche Zunahme der vollvernetzten Keilstufen zur Folge hat. In Klammern ist die Zahl der nahezu vollständig vernetzten Keilstufen angegeben.

| Keilstufen | Belichtungszeit (Sekunden) 5 | 10 | 20 | 40 |
|---|---|---|---|---|
| ohne Nacherhitzung | 3 (4) | 5 | 7 (8) | 9 (10) |
| mit Nacherhitzung | 9 (10) | 10 (11) | 12 (13) | 13 |

Ein Vergleich der vollvernetzten Keilstufen der 40 Sekunden belichteten Druckplatte mit Deckschicht (9 (10)) mit denen der entsprechenden Platte ohne Deckschicht (7; Beispiel 4) zeigt, daß die Schicht nur wenig empfindlich gegenüber Sauerstoff ist.

Schichten mit anderen Monomeren (z. B. Trimethylolethantriacrylat) vernetzten unter Sauerstoffeinfluß (d. h. ohne Deckschicht) wesentlich weniger als mit Deckschicht. (4 Keilstufen ohne, 9 Keilstufen mit Deckschicht, bei 40 Sekunden Belichtungszeit).

## Beispiel 6

Auf den in Beispiel 1 angegebenen Schichtträger wurden Lösungen folgender Zusammensetzung so aufgeschleudert, daß nach dem Trocknen ein Schichtgewicht von 2,5 g/m$^2$ erhalten wurde:

2 Gt des in Beispiel 1 angegebenen Mischpolymerisats,
1,6 Gt einer der folgenden Verbindungen
- a) Oligourethan aus 2 Mol Glycerindimethacrylat, 2 Mol Hexamethylendiisocyanat und 1 Mol Polyethylenglykol 200,
- b) Analoges Oligourethan mit 1 Mol Polyethylenglykol 300,
- c) Analoges Oligourethan mit 1 Mol Polyethylenglykol 600,
- d) Analoges Oligourethan mit 1 Mol Polyethylenglykol 1000,
- e) Analoges Oligourethan mit 1 Mol Dipropylenglykol,
- f) Analoges Oligourethan mit 1 Mol Polypropylenglykol 400,

0,5 Gt 9-Phenyl-acridin und
0,05 Gt des Azofarbstoffs aus Beispiel 1 in
23 Gt Butanon,
12 Gt Butylacetat und
12 Gt Ethylenglykolmonomethylether.

Die Platten wurden 40 Sekunden belichtet und mit der in Beispiel 1 angegebenen Entwicklerlösung entwickelt.

Es wurde die folgende Anzahl vollvernetzter Keilstufen erhalten:

| Monomeres | Entwicklungszeit (Sekunden) | Keilstufen |
|---|---|---|
| a | 15 | 5 (6) |
| b | 10 | 6 (7) |
| c | 5 | 8 (9) |
| d | 5 | 4 (5) |
| e | 45 | 3 (4) |
| f | 30 | 4 |

Beispiel 7

Es wurden Beschichtungslösungen aus

2 Gt des in Beispiel 1 angegebenen Mischpolymerisats,
2 Gt eines der folgenden Monomeren
a) 2,2-Bis-[4-(2-acryloyloxy-propoxy)-phenyl]propan,
b) Trimethylolethantriacrylat,
c) Umsetzungsprodukt aus 1 Mol 2,2,4-Trimethyl-hexamethylendiisocyanat und 2 Mol Hydroxyethylmethacrylat,
d) Umsetzungsprodukt aus 1 Mol Triethylenglykol, 2 Mol 2,2,4-Trimethyl-hexamethylendiisocyanat und 2 Mol Hydroxyethylmethacrylat,
e) Diurethan aus Beispiel 1,
f) Oligourethan aus Beispiel 4,
0,125 Gt 9-Phenyl-acridin und
0,05 Gt des Azofarbstoffs aus Beispiel 1 in
27 Gt Butanon und
12 Gt Butylacetat

hergestellt und auf elektrolytisch aufgerauhtes und anodisiertes Aluminium so aufgeschleudert, daß ein Trockenschichtgewicht von 3,5 g/m² erhalten wurde. Die Platten wurden 10, 20 und 40 Sekunden belichtet und anschließend manuell 90 Sekunden mit dem in Beispiel 1 angegebenen Entwickler entwickelt.

In einem anderen Versuch wurden die Platten 1 Stunde bei 100° C im Umlufttrockenschrank gelagert, danach 40 Sekunden belichtet und 90 Sekunden entwickelt. Die Ergebnisse sind in der folgenden Tabelle zusammengefaßt:

| Monomeres | Entwicklungszeit (Sekunden) | Belichtungszeit (Sekunden) 10 | 20 | 40 | 40 (1 Std. 100° C) |
|---|---|---|---|---|---|
| | | Keilstufen | | | |
| a | 30 | 2 (3) | 3 (4) | 4 (5) | 3 |
| b | 20 | 2 | 3 | 4 | 0 |
| c | 20 | 3 (4) | 3 (4) | 4 (5) | 2 (3) |
| d | 25 | 2 | 4 | 5 | 5 |
| e | 20 | 1 | 3 | 5 | 5 |
| f | 5 | 2 (3) | 4 (5) | 6 (7) | 6 (7) |

Es wird deutlich, daß die vier Vergleichsmonomeren sowohl bezüglich Entwicklungszeit, Reziprozität als auch Flüchtigkeit (100° C-Test) Nachteile gegenüber den in dieser Anmeldung beschriebenen Verbindungen (e, f) aufweisen.

## Beispiel 8

Eine Lösung von

| | |
|---|---|
| 6,5 Gt | eines Terpolymerisats aus n-Hexylmethacrylat, Methacrylsäure und Styrol (60 : 30 : 10) mit einem mittleren Molekulargewicht von ca. 35 000, |
| 5,6 Gt | des in Beispiel 1 beschriebenen Diurethans, |
| 0,2 Gt | 9-Phenyl-acridin und |
| 0,02 Gt | des Azofarbstoffs aus Beispiel 1 in |
| 25 Gt | Butanon und |
| 3 Gt | Ethanol |

wurde auf eine biaxial verstreckte und thermofixierte Polyethylenterephthalatfolie der Stärke 25 µm so aufgeschleudert, daß nach dem Trocknen bei 100° C ein Schichtgewicht von 33 g/m² erhalten wurde.

Die so hergestellte Trockenresistfolie wurde mit einer handelsüblichen Laminiervorrichtung bei 120° C auf eine mit 35 µm starker Kupferfolie kaschierte Phenoplast-Schichtstoffplatte laminiert und 20 Sekunden mit einem handelsüblichen Belichtungsgerät belichtet. Als Vorlage diente eine Strichvorlage mit Linienbreiten und Abständen bis herab zu 80 µm.

Nach der Belichtung wurde die Polyesterfolie abgezogen und die Schicht mit der in Beispiel 1 beschriebenen Entwicklerlösung in einem Sprühentwicklungsgerät 90 Sekunden lang entwickelt.

Die Platte wurde dann 30 Sekunden mit Leitungswasser gespült, 30 Sekunden in einer 15%igen Ammoniumperoxydisulfat-Lösung angeätzt, erneut mit Wasser gespült, 30 Sekunden in 10%ige Schwefelsäure getaucht und sodann nacheinander in den folgenden Elektrolytbädern galvanisiert:

1. 30 Minuten in einem Kupferelektrolytbad der Firma Schlötter, Geislingen/Steige, Typ »Glanzkupfer-Bad«
   Stromdichte: 2,5 A/dm²
   Metallaufbau: ca. 15 µm
   Temperatur: Raumtemperatur

2. 10 Minuten in einem Nickelbad Typ »Norma« der Firma Schlötter, Geislingen/Steige
   Stromdichte: 4 A/dm²
   Metallaufbau: 10 µm
   Temperatur: 50° C

Die Platte zeigte keinerlei Unterwanderungen oder Beschädigungen.

Die Platte konnte sodann in 5%iger KOH-Lösung bei 50° C entschichtet und das freigelegte Kupfer in den üblichen Ätzmedien weggeätzt werden.

## Beispiel 9

Die in Beispiel 8 beschriebene Resistlösung wurde auf eine mit 35 µm starker Kupferfolie kaschierte Phenoplast-Schichtstoffplatte aufgeschleudert und getrocknet (30 g/m²).

Analog zu Beispiel 8 wurde die Platte belichtet, entwickelt und galvanisiert, wobei an Stelle der Vernickelung wie folgt verfahren wurde:

15 Minuten in einem Bleizinnbad LA der Firma Schlötter, Geislingen/Steige
Stromdichte: 2 A/dm²
Metallaufbau: 15 µm
Temperatur: Raumtemperatur

Auch diese Platte zeigte keinerlei Unterwanderungen oder Beschädigungen und ließ sich mit KOH-Lösung entschichten und mit üblichen Ätzmitteln ätzen.

Beispiel 10

Eine Lösung aus

6,5 Gt des in Beispiel 8 angegebenen Terpolymerisats,
5,6 Gt des Oligourethans aus Beispiel 4,
0,2 Gt 9-Phenyl-acridin und
0,02 Gt des Azofarbstoffs aus Beispiel 1 in
25 Gt Butanon und
3 Gt Ethanol

wurde auf einen gereinigten Träger, der aus einem Isolierstoffmaterial mit 35 µm Kupferauflage bestand, so aufgeschleudert, daß eine Trockenschichtdicke von 4 µm erhalten wurde. Die Schicht wurde 2 Minuten bei 100°C im Umlufttrockenschrank getrocknet. Anschließend wurde mittels einer 5 kW-Lampe 40 Sekunden belichtet. Als Vorlage diente die in Beispiel 8 beschriebene Strichvorlage. Nach der Belichtung wurde die Platte mit 0,8%iger Sodalösung in einem Sprühprozessor 45 Sekunden entwickelt.

Die Platte wurde gespült, angeätzt und dann wie folgt galvanisiert:

1. 8 Minuten in dem in Beispiel 8 beschriebenen »Glanzkupferbad«
   Stromdichte: 2,5 A/dm²
   Metallaufbau: ca. 4 µm
   Temperatur: Raumtemperatur

2. 2 Minuten in dem in Beispiel 8 beschriebenen Nickelbad »Norma«
   Stromdichte: 4 A/dm²
   Metallaufbau: ca. 2 µm
   Temperatur: 50°C

Es zeigten sich keinerlei Unterwanderungen.

Die Platte konnte in 5%iger KOH-Lösung bei 50°C entschichtet und das freigelegte Kupfer in den üblichen Ätzmedien weggeätzt werden.

Beispiel 11

Auf den in Beispiel 1 angegebenen Schichtträger wurden Lösungen folgender Zusammensetzung so aufgeschleudert, daß Schichtgewichte von 2,2 g/m² erhalten wurden:

2 Gt eines Styrol/Maleinsäureanhydrid-Mischpolymerisats (1 : 1, Molekulargewicht 50 000), welches mit Hydroxyethylmethacrylat umgesetzt worden war (MG des umgesetzten Produkts etwa 80 000),
2 Gt eines der folgenden Monomeren
   a) Diurethan aus 2 Mol Glycerindimethacrylat und 1 Mol Hexamethylendiisocyanat,
   b) Oligourethan aus 2 Mol Glycerindimethacrylat, 2 Mol Hexamethylendiisocyanat und 1 Mol Polytetrahydrofurandiol (Handelsprodukt mit dem Molekulargewicht 1000),
   c) Oligourethan aus 2 Mol Glycerindimethacrylat, 2 Mol Hexamethylendiisocyanat und 1 Mol Polycaprolactondiol (MG 830),
   d) Oligourethan aus 2 Mol Glycerindimethacrylat, 2 Mol Hexamethylendiisocyanat und 1 Mol Polyethylenglykol 400,
   e) Oligourethan aus 2 Mol Glycerindimethacrylat, 2 Mol Hexamethylendiisocyanat und 1 Mol 4,4'-Dihydroxydiphenylsulfon,
   f) Analoges Oligourethan mit 1 Mol Bisphenol A,
   g) Analoges Oligourethan mit 1 Mol des Reaktionsprodukts aus 1 Mol Bisphenol A und 2 Mol Ethylenoxid,
   h) Analoges Oligourethan mit 1 Mol des Reaktionsprodukts aus 1 Mol Bisphenol A und 8 Mol Ethylenoxid,
   i) Anloges Oligourethan mit 1 Mol des Reaktionsprodukts aus 1 Mol Bisphenol A und 16 Mol Ethylenoxid
   k) Diurethan aus 1 Mol Hexamethylendiisocyanat und 2 Mol des Umsetzungsprodukts aus 1 Mol Glycidylmethacrylat und 1 Mol Acrylsäure,
   l) Diurethan aus 2 Mol Glycerindiacrylat und 1 Mol Hexamethylendiisocyanat,
   m) Tetraurethan aus 2 Mol Glycerindimethacrylat und 1 Mol des Reaktionsprodukts aus 2 Mol Tolylendiisocyanat und 1 Mol Polytetrahydrofurandiol (MG um 2000),

0,7 Gt 9-Phenyl-acridin,
0,07 Gt des Azofarbstoffs aus Beispiel 1,
32 Gt Butanon,
12 Gt Butylacetat,
12 Gt Ethylenglykolmonomethylether.

Die Platten wurden 40 Sekunden wie in Beispiel 1 belichtet und mit der in Beispiel 1 angegebenen Entwicklerlösung entwickelt.
In der folgenden Tabelle sind Keilstufenzahl und Entwicklungszeit angegeben:

| Monomeres | Entwicklungszeit (Sekunden) | Keilstufen |
|---|---|---|
| a | 7 | 7 (8) |
| b | 7 | 10 (11) |
| c | 7 | 9 (10) |
| d | 5 | 10 |
| e | 5 | 2 (3) |
| f | >30 | 2 |
| g | >30 | 3 (4) |
| h | 7 | 8 (9) |
| i | 7 | 11 |
| k | 5 | 7 (8) |
| l | 5 | 5 (6) |
| m | 7 | 10 (11) |

## Beispiel 12

Ersetzt man das in Beispiel 11 angegebene Bindemittel durch ein Styrol/Maleinsäuremonoallylester-Copolymeres (MG ~ 64 000), so erhält man bei sonst gleicher Rezeptur für das Monomere a aus Beispiel 11 6 (7), für das Monomere c 8 (9) vollvernetzte Keilstufen. Die Entwicklungszeit ist in beiden Fällen kürzer als 5 Sekunden.

## Beispiel 13

Es wurden Beschichtungslösungen aus

1,6 Gt des in Beispiel 1 angegebenen Mischpolymerisats,
0,4 Gt eines Methylvinylether-Maleinsäuremonobutylester-Mischpolymerisats mit einer Säurezahl um 260,
2 Gt eines der folgenden Monomeren
- a) Umsetzungsprodukt aus 2 Mol Glycerindimethacrylat und 1 Mol Hexamethylendiisocyanat,
- b) Umsetzungsprodukt aus 3 Mol Glycerindimethacrylat, 3 Mol Hexamethylendiisocyanat und 1 Mol Trimethylolethan,
- c) Umsetzungsprodukt aus 3 Mol Glycerindimethacrylat, 3 Mol Hexamethylendiisocyanat und 1 Mol Trimethylolpropan,

0,7 Gt 9-Phenyl-acridin,
0,07 Gt des Azofarbstoffs aus Beispiel 1 in
30 Gt Butanon,
12 Gt Butylacetat und
12 Gt Ethylenglykolmonomethylether

hergestellt und auf elektrolytisch aufgerauhtes und anodisiertes Aluminium so aufgeschleudert, daß ein Trockengewicht von 2,5 g/m² erhalten wurde.

Die Platten wurden 40 Sekunden belichtet und mit der in Beispiel 1 angegebenen Entwicklerlösung entwickelt.

Es wurde die folgende Anzahl vollvernetzter Keilstufen erhalten.

| Monomeres | Entwicklungszeit (Sekunden) | Keilstufen |
|---|---|---|
| a | 10 | 6 (7) |
| b | 30 | 6 (7) |
| c | 35 | 5 (7) |

Beispiel 14

Auf einen Silicium-Wafer mit einer 1 µm starken Siliciumdioxidschicht wurde eine Beschichtungslösung aus

| | |
|---|---|
| 6,5 Gt | des in Beispiel 8 angegebenen Terpolymerisats, |
| 5,0 Gt | des Diurethans aus Beispiel 1, |
| 0,7 Gt | 9-Phenylacridin und |
| 0,125 Gt | eines blauen Farbstoffs, erhalten durch Kuppeln von 2,4-Dinitro-6-chlor-benzoldiazoniumsalz mit 2-Methoxy-5-acetylamino-N,N-diethylanilin, in |
| 30 Gt | Butanon und |
| 28 Gt | Ethylenglykolmonomethylether |

so aufgeschleudert, daß ein Trockengewicht von 1 g/m² erhalten wurde (Trocknung 10 Minuten, 80° C).

Die Probe wurde mittels eines Belichtungsgeräts durch eine Testvorlage mit Strukturen bis zu 1,5 µm 6 Sekunden belichtet (Bestrahlungsstärke: 8,4 mW/cm²) und dann 45 Sekunden in 0,8%iger Natriumcarbonatlösung entwickelt. Anschließend wurde 10 Minuten in einer Mischung aus 70 g Ammoniumfluorid, 31 ml 40%iger Flußsäure und 105 ml deionisiertem Wasser bei 23° C geätzt und dann 2 Minuten in einem Gemisch aus 300 ml 98%iger Schwefelsäure und 50 ml 35%iger Wasserstoffperoxidlösung bei 110° C entschichtet.

Es wurden Strukturen bis 1,5 µm kantenscharf abgebildet.

**Patentansprüche**

1. Durch Strahlung polymerisierbares Gemisch, das als wesentliche Bestandteile

a) ein polymeres Bindemittel,
b) einen durch Strahlung aktivierbaren Polymerisationsinitiator und
c) einen Acryl- oder Methacrylsäureester einer mehrwertigen Hydroxyverbindung mit mindestens zwei Urethangruppen im Molekül

enthält, dadurch gekennzeichnet, daß der Ester ein Umsetzungsprodukt aus Glycerindimethacrylat oder Glycerindiacrylat und einem mehrwertigen Isocyanat, das durch Umsetzen einer Polyhydroxyverbindung mit 2 bis 6 OH-Gruppen mit einem Diisocyanat erhalten worden ist, oder einem Diisocyanat ist.

2. Durch Strahlung polymerisierbares Gemisch nach Anspruch 1, dadurch gekennzeichnet, daß die Polyhydroxyverbindung eine Verbindung einer der folgenden allgemeinen Formeln

$HO-[C_pH_{2p-v}(OH)_v-S-]_{m-1}C_pH_{2p-v}(OH)_{v+1}$,
$HO-[C_pH_{2p-v}(OH)_v-O-]_mH$,
$HO-C_rH_{2r-2-v}(OH)_{v+1}$,
$HO-C_sH_{2s-v}(OH)_v-Z(-CO-C_qH_{2q}-O)_m-H$,
$HO-[C_qH_{2q-v}(OH)_v-O-CO-Q-COO]_m-C_qH_{2q-v}(OH)_{v+1}$ und

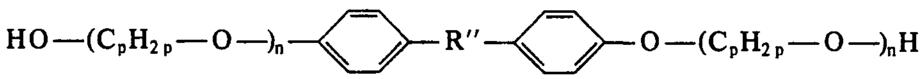

ist, worin

R″ O, S, $CR_2$ oder $SO_2$,
Q eine Phenylengruppe oder eine der Gruppen

$C_qH_{2q}$ und
$C_qH_{2q-2}$,

R ein Wasserstoffatom oder eine Methylgruppe,
Z O oder NR,
n eine Zahl von 0 bis 20,
m eine Zahl von 1 bis 40,
p eine Zahl von 2 bis 20,
q eine Zahl von 2 bis 10,
r eine Zahl von 4 bis 20,
s eine Zahl von 2 bis 10 und
v eine Zahl von 0 bis 4

bedeuten, wobei p, q und s um mindestens 2 und r um mindestens 4 größer sind als v.

3. Durch Strahlung polymerisierbares Gemisch nach Anspruch 1, dadurch gekennzeichnet, daß der Ester 2 bis 40 Urethangruppen enthält.

4. Durch Strahlung polymerisierbares Gemisch nach Anspruch 1, dadurch gekennzeichnet, daß der Ester ein Methacrylsäureester ist.

5. Durch Strahlung polymerisierbares Gemisch nach Anspruch 1, dadurch gekennzeichnet, daß das Diisocyanat eine Verbindung der Formel OCN—X—NCO ist, worin X ein Kohlenwasserstoffrest mit 2 bis 20 Kohlenstoffatomen ist.

6. Photopolymerisierbares Aufzeichnungsmaterial mit einem Schichtträger und einer photopolymerisierbaren Schicht, die als wesentliche Bestandteile

a) ein polymeres Bindemittel,
b) einen durch Strahlung aktivierbaren Polymerisationsinitiator und
c) einen Acryl- oder Methacrylsäureester einer mehrwertigen Hydroxyverbindung mit mindestens zwei Urethangruppen im Molekül

enthält, dadurch gekennzeichnet, daß der Ester ein Umsetzungsprodukt aus Glycerindimethacrylat oder Glycerindiacrylat und einem mehrwertigen Isocyanat, das durch Umsetzen einer Polyhydroxyverbindung mit 2 bis 6 OH-Gruppen mit einem Diisocyanat erhalten worden ist, oder einem Diisocyanat ist.

**Claims**

1. A mixture which is polymerizable by radiation and which contains, as the essential constituents,

a) a polymeric binding agent,
b) a polymerization initiator which can be activated by radiation and
c) an acrylate or methacrylate of a polyhydric hydroxy compound having at least two urethane groups in the molecule,

characterized in that the ester is a reaction product of glycerol dimethacrylate or glycerol diacrylate and a polyisocyanate which has been obtained by reacting a polyhydroxy compound having 2 to 6 OH groups with a diisocyanate, or a reaction product of glycerol dimethacrylate or glycerol diacrylate and a diisocyanate.

2. A mixture which is polymerizable by radiation as claimed in Claim 1, characterized in that the polyhydroxy compound is a compound of one of the following general formulas

$HO-[C_pH_{2p-v}(OH)_v-S-]_{m-1}C_pH_{2p-v}(OH)_{v+1}$,
$HO-[C_pH_{2p-v}(OH)_v-O-]_mH$,
$HO-C_rH_{2r-2-v}(OH)_{v+1}$,
$HO-C_sH_{2s-v}(OH)_v-Z(-CO-C_qH_{2q}-O)_m-H$,
$HO-[C_qH_{2q-v}(OH)_v-O-CO-Q-COO]_m-C_qH_{2q-v}(OH)_{v+1}$ and

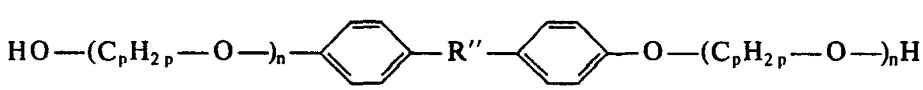

wherein

R'' is O, S, $CR_2$ or $SO_2$,
Q is a phenylene group or one of the groups

$C_qH_{2q}$ and
$C_qH_{2q-2}$,

R is a hydrogen atom or a methyl group,
Z is O or NR,
n is an integer from 0 to 20,
m is an integer from 1 to 40,
p is an integer from 2 to 20,
q is an integer from 2 to 10,
r is an integer from 4 to 20,
s is an integer from 2 to 10,
v is an integer from 0 to 4,

p, q, and s being at least by 2 greater than v, and r being at least by 4 greater than v.

3. A mixture which is polymerizable by radiation as claimed in Claim 1, characterized in that the ester contains 2 to 40 urethane groups.

4. A mixture which is polymerizable by radiation as claimed in Claim 1, characterized in that the ester is a methacrylic acidester.

5. A mixture which is polymerizable by radiation as claimed in Claim 1, characterized in that the diisocyanate is a compound of the formula OCN—X—NCO, wherein X means a hydrocarbon radical having 2 to 20 carbon atoms.

6. A photopolymerizable reproduction material comprising a layer support and a photopolymerizable layer which, as the essential components, contains

a) a polymeric binding agent,
b) a polymerization initiator which can be activated by radiation and
c) an acrylate or methacrylate of a polyhydric hydroxy compound having at least two urethane groups in the molecule,

characterized in that the ester is a reaction product of glycerol dimethacrylate or glycerol diacrylate and a polyisocyanate which has been obtained by reacting a polyhydroxy compound having 2 to 6 OH groups with a diisocyanate, or a reaction product of glycerol dimethacrylate or glycerol diacrylate and a diisocyanate.

**Revendications**

1. Mélange polymérisable par rayonnement, qui contient comme constituants essentiels:

a) un liant polymère,
b) un initiateur de polymérisation activable par rayonnement et
c) un acrylate ou un méthacrylate d'un composé hydroxylé polyvalent ayant au moins 2 groupes uréthanne dans la molécule,

caractérisé en ce que l'ester est un produit de réaction de diméthacrylate de glycérol ou de diacrylate de glycérol et d'un isocyanate polyvalent, qui a été obtenu par réaction d'un composé polyhydroxylé ayant de 2 à 6 groupes OH avec un diisocyanate, ou d'un diisocyanate.

2. Mélange polymérisable par rayonnement selon la revendication 1, caractérisé en ce que le composé polyhydroxylé est un composé répondant à l'une des formules suivantes:

$HO-[C_pH_{2p-v}(OH)_v-S-]_{m-1}C_pH_{2p-v}(OH)_{v+1}$,
$HO-[C_pH_{2p-v}(OH)_v-O-]_mH$,
$HO-C_rH_{2r-2-v}(OH)_{v+1}$,
$HO-C_sH_{2s-v}(OH)_v-Z(-CO-C_qH_{2q}-O)_m-H$,
$HO-[C_qH_{2q-v}(OH)_v-O-CO-Q-COO]_m-C_qH_{2q-v}(OH)_{v+1}$ et

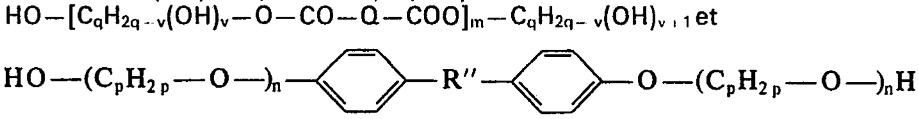

dans lesquelles

R'' représente O, S, $CR_2$ ou $SO_2$,
Q représente un groupe phénylène ou un des groupes

$C_qH_{2q}$ et
$C_qH_{2q-2}$

R représente un atome d'hydrogène ou un groupe méthyle,
Z représente O ou NR,
n est un nombre de 0 à 20,
m est un nombre de 1 à 40,
p est un nombre de 2 à 20,
q est un nombre de 2 à 10,
r est un nombre de 4 à 20,
s est un nombre de 2 à 10 et
v est un nombre de 0 à 4,

p, q et s étant au minimum 2 fois supérieurs à v et r étant au minimum 4 fois supérieur à v.

3. Mélange polymérisable par rayonnement selon la revendication 1, caractérisé en ce que l'ester contient de 2 à 40 groupes uréthanne.

4. Mélange polymérisable par rayonnement selon la revendication 1, caractérisé en ce que l'ester est un ester d'acide méthacrylique.

5. Mélange polymérisable par rayonnement selon la revendication 1, caractérisé en ce que le diisocyanate est un composé de formule OCN—X—NCO, dans lequel X est un radical hydrocarboné ayant de 2 à 20 atomes de carbone.

6. Matériau d'enregistrement photopolymérisable avec un support de couche et une couche photopolymérisable, qui contient comme constituants essentiels:

a) un liant polymère,
b) un initiateur de polymérisation activable par rayonnement et
c) un acrylate ou un méthacrylate d'un composé hydroxylé polyvalent avec au moins 2 groupes uréthanne dans la molécule,

caractérisé en ce que l'ester est un produit de réaction de diméthacrylate de glycérol ou de diacrylate de glycérol et d'un isocyanate polyvalent, qui a été obtenu par réaction d'un composé polyhydroxylé ayant de 2 à 6 groupes OH avec un diisocyanate, ou d'un diisocyanate.